(19) **Europäisches Patentamt**
**European Patent Office**
**Office européen des brevets**

(11) **EP 4 469 618 B1**

(12) **EUROPÄISCHE PATENTSCHRIFT**

(45) Veröffentlichungstag und Bekanntmachung des Hinweises auf die Patenterteilung:
**10.09.2025  Patentblatt 2025/37**

(21) Anmeldenummer: **23701363.6**

(22) Anmeldetag: **19.01.2023**

(51) Internationale Patentklassifikation (IPC):
*C23C 16/30* (2006.01)      *C23C 16/52* (2006.01)
*H01L 21/687* (2006.01)     *C23C 16/46* (2006.01)
*G01J 5/00* (2022.01)       *G01J 5/80* (2022.01)
*H01L 21/67* (2006.01)

(52) Gemeinsame Patentklassifikation (CPC):
**G01J 5/0007; C23C 16/303; C23C 16/46;
C23C 16/52; G01J 5/0022; G01J 5/80;
H01L 21/6723; H01L 21/67248; H01L 21/68771;
H01L 21/68785**

(86) Internationale Anmeldenummer:
**PCT/EP2023/051161**

(87) Internationale Veröffentlichungsnummer:
**WO 2023/143987 (03.08.2023 Gazette 2023/31)**

(54) **VERFAHREN ZUR EMISSIVITÄTSKORRIGIERTEN PYROMETRIE**

METHOD FOR EMISSIVITY-CORRECTED PYROMETRY

PROCÉDÉ DE PYROMÉTRIE À ÉMISSIVITÉ CORRIGÉE

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorität: **26.01.2022  DE 102022101809**

(43) Veröffentlichungstag der Anmeldung:
**04.12.2024  Patentblatt 2024/49**

(73) Patentinhaber: **Aixtron SE
52134 Herzogenrath (DE)**

(72) Erfinder: **ROJEK, Karsten
41061 Mönchengladbach (DE)**

(74) Vertreter: **Grundmann, Dirk et al
Rieder & Partner mbB
Patentanwälte - Rechtsanwalt
Yale-Allee 26
42329 Wuppertal (DE)**

(56) Entgegenhaltungen:
**US-B1- 6 349 270**

- **YAN DONG ET AL: "In-Situ Temperature Monitoring and Deposition Induced Errors Calibration in Metal-Organic Chemical Vapor Deposition", 2013 THIRD INTERNATIONAL CONFERENCE ON INSTRUMENTATION, MEASUREMENT, COMPUTER, COMMUNICATION AND CONTROL, IEEE, 21 September 2013 (2013-09-21), pages 897 - 900, XP032609647, DOI: 10.1109/IMCCC.2013.199**

**Beschreibung**

**Gebiet der Technik**

Die Erfindung betrifft ein Verfahren zum Beschichten eines Substrates mit mindestens einer Schicht, wobei während des Abscheidens der Schicht mit mindestens einer optischen Messeinrichtung an der Schicht mehrfach hintereinander Messwertpaare, die jeweils einen Emissionswert und einen Reflektanzwert beinhalten, gemessen werden, wobei aus den Messwertpaaren und einem zuvor bestimmten Korrekturwert Temperaturwerte einer Substrattemperatur berechnet werden. Diese können als Istwerte verwendet werden, mit denen eine Temperiereinrichtung zum Temperieren des Substrates gegen einen Sollwert geregelt wird.

Die Erfindung betrifft darüber hinaus eine Messvorrichtung mit einer Recheneinrichtung, die programmierbar ist und derart programmiert ist, dass Korrekturwerte nach diesem Verfahren berechnet werden.

**Stand der Technik**

Die US 6,398,406 B1 bildet den technischen Hintergrund der Erfindung. Das dort beschriebene Verfahren der emissivitätskorrigierten Pyrometrie, auch als reflektivitäts- oder reflektanzkorrigiert oder emissivitätskompensiert bezeichnet, ermöglicht die berührungsfreie optische Temperaturmessung während einer Dünnschichtabscheidung bei unbekannten und sich fortlaufend ändernden optischen Eigenschaften des Messobjekts. Bei dem Verfahren der Pyrometrie zur berührungsfreien Temperaturmessung macht man sich den Zusammenhang zwischen der von dem heißen Messobjekt emittierten thermischen Strahlung und der Temperatur des Objekts zu Nutze, der durch die bekannte Planck'sche Strahlungsgleichung beschrieben wird und in der Praxis durch eine entsprechende vorhergehende Kalibration bis auf den Emissionsgrad des Objekts eindeutig erfasst wird. Das Messobjekt kann jede für die Überwachung oder Regelung der Temperatur relevante und optisch zugängliche Oberfläche in der Prozesskammer sein. Für diese Erfindung ist das Messobjekt insbesondere die Oberfläche des Substrats bzw. der Substrate in der Prozesskammer während des Abscheidungsprozesses, bei dem eine Halbleiterschichtstruktur mit unterschiedlichen nahezu stöchiometrischen Verbindungen aus der Gruppe III (Al, Ga, In) und aus Stickstoff erzeugt wird.

Stand der Technik ist auch folgende Veröffentlichung:

W. G. Breiland, Technical Report SAND2003-1868, June 2003, öffentlich zugänglich z.B.:

> https://www.osti.gov/biblio/820889 oder
> https: / /prod-ng.sandia.gov/ techlib-noauth/ access-control.cgi/2003/031868.pdf
> nachfolgend mit Breiland 2003 bezeichnet.

Zum Stand der Technik gehört auch die DE 10 2018 106 481 A1, die eine gattungsgemäße Vorrichtung beschreibt.

Die DE 44 19 476 C2 beschreibt ein Verfahren, mit dem die emittierte und die reflektierte Strahlung von einem Substrat während des Abscheidens einer Schicht gemessen werden kann.

Die DE 10 2020 111 293 A1 beschreibt die emissivitätskorrigierte Pyrometrie zur Minimierung einer Restoszillation.

Das bekannte Verfahren der Emissivitätskorrektur beruht darauf, den fehlenden unbekannten Emissionsgrad durch Messung der Reflektanz der Oberfläche des Messobjekts zu bestimmen. Die Emissivität wird mit Hilfe des Kirchhoff'schen Gesetzes für den Fall lichtundurchlässiger Substrate zu $\varepsilon = 1-\rho$ ermittelt. Die Detektionswellenlänge des Pyrometers wird so gewählt, dass das gewählte Substrat (hier Silizium) für die Wellenlänge bei den typischen Betriebstemperaturen (T = 600 - 1200°C) lichtundurchlässig ist, also bei Werten in der Spanne 800 nm bis 1000 nm. Die Reflektanz wird bei exakt derselben Wellenlänge wie die thermische Emission gemessen, damit das Verfahren ausreichend genau funktioniert. Das hierzu erforderliche Licht kann von einem Laser bereitgestellt werden. In der Praxis haben die Pyrometer keine scharfe Messwellenlänge sondern weisen ein Wellenlängenintervall auf (etwa $\pm$ 10 nm, aber auch enger oder weiter). Diese Intervallbreite und die effektive Wellenlänge von Emissions- und Reflektanzmessung müssen möglichst gut übereinstimmen. Die Reflektanz wird gemessen, indem Licht der definierten Wellenlänge am Ort des Sensors ausgesandt wird, bei vertikalem Einfall an der Waferoberfläche reflektiert wird und möglichst am selben Ort wie die Pyrometermessung reflektiert wird. Aus der gemessenen Signalintensität des reflektierten Lichts wird mit Hilfe einer vorhergehenden Kalibration die Reflektanz bestimmt. In der Praxis kann die thermische Emission des Objekts und die Reflektanz oftmals nicht gleichzeitig sondern alternierend zeitlich getrennt gemessen werden, damit die Reflektanzmessung nicht die Messung der thermischen Emission stört. Siehe hierzu auch die in der DE 44 19 476 C2 genannte Lock-In-Technik.

Für die genaue Messung der Temperatur sind zwei unterschiedliche Kalibrierschritte erforderlich; die Durchführung der Kalibrierungen erlaubt die Bestimmung von Kalibrierparametern, welche in die Berechnung der Temperatur aus den Messsignalen einfließen. Es handelt sich dabei um die Kalibrierung der Emissionsmessung unter Verwendung einer Schwarzkörperstrahlungsquelle (Schwarzkörperofen, spezielle Referenzquellen), welche die Verknüpfung von Intensitätssignal und Messtemperatur herstellt. Bei der Messung erlaubt die Verwendung der so ermittelten Kalibrierparameter die Ermittlung der noch nicht um den Effekt der unbekannten Emissivität korrigierten sogenannten Rohtemperatur.

Ein davon unabhängiger Kalibrierschritt dient der Ermittlung eines Kalibrierparameters, so dass jedem gemessenen Reflektanzsignal ein Reflektanzwert aus dem Intervall 0...1 zugeordnet wird. Dieser Kalibrierschritt wird auf Substraten gut bekannter Reflektanz (beziehungsweise Emissionsgrad bei opaken Substraten) durchgeführt, etwa Silizium unmittelbar nach dem Prozessschritt der Desorption (native oxide removal) bei bekannter Temperatur und nicht verunreinigter Oberfläche und noch vor dem Beginn der Schichtabscheidung.

Beim Abscheiden einer dünnen Schicht mit konstanter Wachstumsgeschwindigkeit wird ohne den Einsatz des bekannten Verfahrens der Emissivitätskorrektur eine sinusförmig oszillierende Temperaturmessung beobachtet, die mit den Interferenzeffekten in der durchsichtigen dünnen Schicht zusammenhängen (Fabry-Perot-Oszillationen). Im konkreten Fall der MOCVD Abscheidung von GaN oder AlGaN auf Silizium bei Temperaturen im Bereich von 950 bis 1100°C betragen die Oszillationen bis zu $\pm 30°C$. Ziel des Verfahrens ist es, die Temperaturoszillationen auf unter $\pm 2°C$, besser noch $\pm 1°C$ zu reduzieren.

Führt man das im Stand der Technik beschriebene Temperaturmessverfahren wie beschrieben aus, tritt eine Reihe von Fehlern auf, die im Folgenden beschrieben werden. Diese Fehlerquellen führen allesamt dazu, dass die Emissivitätskorrektur unvollständig oder artifiziell überhöht durchgeführt wird. Die fehlerhafte Emissivitätskorrektur äußert sich in verbleibenden Temperaturoszillationen (Restoszillationen), deren Amplitude größer als das gewünschte Fehlermaß ist.

Es hat sich gezeigt, dass insbesondere das Materialsystem GaN (AlGaN) auf Silizium für die beschriebenen Fehlerquellen besonders anfällig ist, weil aufgrund der Werte der Brechungsindizes für das Schicht- und des Wafermaterial sowie aufgrund des Aufeinandertreffens von lichtdurchlässiger Schicht und opakem Substrat die gemessenen Reflektanzwerte R zwischen Werten von nahe Null und 0.5 oszillieren.

Bei den beobachteten Fehlerquellen kann es sich um folgende Fehler handeln, die auch in der Praxis auftreten:

- Unbekannter exakter Wert der Reflektanz des Kalibrierobjekts bei der Reflektanzkalibrierung, so dass der Wert der bei der Kalibrierung verwendeten Reflektanz nicht mit der physikalischen Reflektanz übereinstimmt, und die für die Emissivitätskorrektur verwendeten Reflektanzwerte fehlerhaft sind;
- Fehler bei der Justage und Einrichtung der Messoptik;
- Streuung an Schichtgrenzen in der Halbleiterschichtstruktur bei der Messung der Reflektanz, so dass ein Teil des tatsächlich reflektierten Lichts nicht erfasst wird;
- Streustrahlung von heißen Oberflächen der Prozesskammer, die durch Mehrfachreflexion an Prozesskammerwänden und an der Waferoberfläche in den Messkopf gelangt.

Bei der Produktion von elektronischen Bauelementen, etwa Transistoren für Schaltungen zur Leistungswandlung oder Hochfrequenzverstärkung ist die Kontrolle und Wiederholgenauigkeit des Abscheidungsprozesses und die Ausbeute der verwendbaren Bauelemente pro Wafer bei der der Erfindung zugrundeliegenden Ausführungsform des bekannten Verfahren stark beeinträchtigt, weil die gemessene Wafertemperatur für die Temperaturregelung in einem geschlossenen Regelkreis verwendet wird. Die Temperaturregelung regelt eine Heizeinrichtung so, dass die gemessene Temperatur konstant einem bestimmten Sollwert entspricht; die physikalische Temperatur oszilliert dann entsprechend um die verbleibende Amplitude der nicht vollständig korrigierten Temperaturoszillationen, die ein Messartefakt darstellen. Das Bauelement besitzt eine auf ein Substrat abgeschiedene Mehrschichtstruktur, die einen ersten Abschnitt und einen zweiten Abschnitt aufweist. Im ersten Abschnitt werden Übergangsschichten, insbesondere AlGaN und Bufferschichten, insbesondere aus GaN abgeschieden. Auf die Bufferschicht aus GaN wird eine AlGaN-Barriereschicht abgeschieden derart, dass sich im Bereich der Schichtgrenze zwischen der GaN-Schicht und der AlGaN-Barriereschicht ein zweidimensionales Elektronengas ausbildet. Die Beeinträchtigung in der Reproduzierbarkeit hängt insbesondere damit zusammen, dass die Bauelementstruktur typischerweise aus einer Abfolge von Funktionsblöcken zusammengesetzt ist, die aus einer dünnen AlN Keimschicht auf dem Si-Substrat, einer Übergangsschichtfolge, einer dicken GaN-Pufferschichtfolge und einer relativ dünnen aber temperaturempfindlichen Barriereschicht aus AlGaN oder AlInN besteht. Am Ende der Pufferschicht wird je nach zufälliger Phasenlage der verbleibenden Messtemperaturoszillation die Abweichung der physikalischen Temperatur vom Sollwert von Run zu Run oder von Wafer zu Wafer unterschiedliche Werte aufweisen, die sich etwa in unterschiedliche Werte der für die Bauelementfunktion kritischen Zusammensetzung der Barriereschicht übertragen.

Für die Kompensation der oben dargestellten Fehlerquellen wird im Stand der Technik folgende theoretische Korrektur dieses Messverfahrens angeführt, die von einer mathematisch herleitbaren Tatsache ausgeht, dass die Auswirkung einer Reihe von Fehlerquellen durch einen zusätzlichen Korrekturwert $\gamma$ effektiv kompensiert werden kann, so dass die verbleibenden Oszillationen theoretisch gegen Null reduziert werden können.

Ein ähnliches Verfahren beschreibt die DE 10 2020 126 597 A1.

**Zusammenfassung der Erfindung**

Ausgangspunkt der Erfindung ist der Zusammenhang zwischen dem im Pyrometer detektierten Messsignal aufgrund der thermischen Emission der Waferoberfläche und der Temperatur der Waferoberfläche, wobei der von eins verschiedene Emissionsgrad der Waferoberfläche aufgrund der sich ändernden physikalischen und optischen Eigenschaften während des Schichtwachstums berücksichtigt wird.

Dieser Zusammenhang wird durch das plancksche Strahlungsgesetz in der Wienschen Näherung beschrieben und hier folgendermaßen dargestellt:

$$U_E = \varepsilon \cdot A \cdot e^{\frac{B}{T}} \qquad (1)$$

wobei

$$\varepsilon = 1 - \alpha \cdot \gamma \cdot U_R \quad (1a).$$

Die Symbole bezeichnen dabei folgende Größen:

$U_E$: Messsignal der thermischen Emission von der Waferoberfläche,
$U_R$: Messsignal der Reflektanz der Oberfläche des Wafers,
$\varepsilon$: Emissionsgrad,
A,B: Kalibrierparameter, wobei B < 0,
$\alpha$: Kalibrierparameter der Reflektanznormierung, der den Zusammenhang zwischen dem Messsignal $U_R$ und der physikalischen Reflektanz R, mit $0 \leq R \leq 1$ herstellt.
$\gamma$: Korrekturwert (Kalibrierparameter) der Streulichtkorrektur, der auch Fehler beim Kalibrierparameter $\alpha$ für die Reflektanzbestimmung kompensieren kann (bis hin zu dem Fall $\alpha$ = 1).

Die Messsignale für die thermische Emission $U_E$ sowie für die Reflektanz der Waferoberfläche $U_R$ werden in möglichst enger zeitlicher und örtlicher Nachbarschaft erfasst. Bei dem Signal, das der thermischen Emission entspricht, handelt es sich um die Strahlungsintensität, die an einem Detektor im Pyrometer erfasst wird und durch die etwa mit Hilfe einer vor der Inbetriebnahme durchgeführten Schwarzkörperkalibrierung ermittelten Kalibrierparameter A und B in einen Temperaturmesswert übersetzt wird. Das Reflektanzsignal wird durch Messung der Intensität eines Lichtsignals erzeugt, das in idealer Weise dieselbe Wellenlänge wie die Messung der thermischen Emission aufweist, vom Messgerät ausgesandt und an der spiegelnden Waferoberfläche in den Detektor reflektiert wird. Aufgrund von optischen Dünnschichteffekten (Fabry-Perot-Effekt) weist die Reflektanz der Waferoberfläche während der Abscheidung der Dünnschichten eine näherungsweise sinusförmige Schwankung über die Zeit auf. Bei den typischen Wachstumsraten von 0,5 bis 5 $\mu$m/h bei GaN-on-Si Prozessen und der verwendeten Wellenlänge bei der Messung von 950nm liegen die Oszillationsperioden bei bis zu 10 Minuten.

Für das weitere Vorgehen bei der kontinuierlichen Ermittlung des Korrekturwertes (Streulichtkalibrierparameters) $\gamma$ wird Gleichung (1) in geeigneter Weise umgeformt:

$$U_E = A \cdot e^{\frac{B}{T}} \cdot (1 - \alpha \cdot \gamma \cdot U_R) \qquad (2),$$

$$U_E = C(T) - C(T) \cdot \alpha \cdot \gamma \cdot U_R \qquad (3)$$

wobei

$$C(T) = A \cdot e^{\frac{B}{T}} \qquad (4).$$

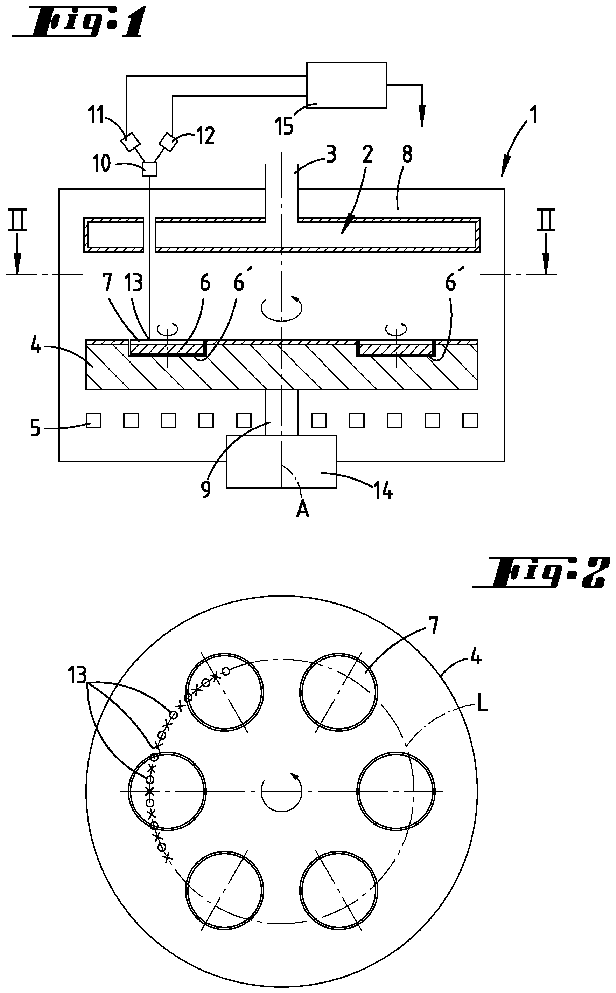

In der spezifischen Ausführung des Verfahrens für einen Planetenreaktor mit mehreren einzelnen Wafer ist das Pyrometer ortsfest an der Oberseite der Prozesskammer auf einem optischen Fenster mit Sichtverbindung zu einem Ort auf der Oberfläche des Substratträgers angebracht. Die Substrate werden aus Gründen der thermischen Mittelung bei der Beschichtung langsam um die Reaktormitte rotiert. Eine typische Rotationsperiode beträgt etwa 12 Sekunden, was fünf Umdrehungen pro Minute entspricht. Die Rotationsrate kann aber auch größer oder geringer sein. An einem bestimmten Ort auf dem Wafer, der für die Messung von Interesse ist, wird somit alle 12 Sekunden ein Messsignalpaar $U_E$ und $U_R$ erfasst. Figuren 1 und 2 zeigen die verwendete Konfiguration. Der Ort der Messung 13 kann auch eine Messzone sein, über die mehrere Messungen erfolgen. Das Messsignalpaar $U_E$ und $U_R$ entspricht den gemittelten Werten über diese Zone. Der Ort 13 oder die Messzone kann auf jedem Wafer 7 liegen und sich in der Wafermitte, am Waferrand oder dazwischen befinden. Für die Anwendbarkeit des Verfahrens besteht die Voraussetzung, dass die Temperatur für eine bestimmte, relativ kleine Anzahl von Umdrehungsperioden, also Vielfache von 12 Sekunden, jedoch mindestens für eine Umdrehung (12 Sekunden in der verwendeten Ausführung), hinreichend konstant ist oder zumindest die Änderung der Temperatur hinreichend gering ist. Diese relativ kurzen Zeitintervalle sollen im Folgenden mit $t_i$ bezeichnet werden. Aufgrund der thermischen Trägheit des Gesamtsystems ist diese Voraussetzung bei der Schichtabscheidung gegeben, wenn man von bewussten Aufheiz- und Abkühlrampen etwa beim Wechsel zwischen Einzelschichten absieht. Insbesondere darf die Temperaturänderung nicht exakt der Restoszillation im Temperatursignal (des zu kompensierenden Messartefakts) in der Frequenz und der Phase entsprechen oder diese kompensieren. Dies ist insofern von Bedeutung, damit eine reale Temperaturänderung aufgrund der sich ändernden Emissivität nicht automatisch fälschlicherweise korrigiert wird. Es hat sich gezeigt, dass für die zuverlässige und genaue Ermittlung des Korrekturwertes (Kalibrierfaktors) $\gamma$ die Rohsignale über eine deutlich längere Zeitspanne erfasst werden müssen als diejenigen Zeitintervalle, für die die Wafertemperatur innerhalb eines engen Toleranzintervalls konstant sein muss. Diese im Verhältnis zu $t_i$ längeren Zeitintervalle sollen im Folgenden mit $t_k$ bezeichnet werden. Der Grund dafür liegt darin, dass für die Ermittlung von $\gamma$ wenigstens eine Viertel Periode der Dünnschichtoszillationen durchlaufen werde muss, für die Erzielung der erforderlichen Genauigkeit jedoch eher eine oder mehrere volle Oszillationsperioden. Die typische Periodenlänge für eine Dünnschichtoszillation liegt bei den typischen Wachstumsraten im GaN-Prozess und der verwendeten Detektionswellenlänge des Pyrometers im Bereich von wenigen Minuten. Die Oszillation ist die Folge von abwechselnd konstruktiver und destruktiver Interferenz des Pyrometer- bzw. Reflektanzsignals in der abgeschiedenen Dünnschicht beim Schichtwachstum.

Der Erfindung liegt die Aufgabe zugrunde, das zuvor beschriebene Verfahren hinsichtlich der Genauigkeit der Bestimmung des Korrekturwertes zu verbessern.

Gelöst wird die Aufgabe durch die in den unabhängigen Ansprüchen angegebenen Merkmale. Die Unteransprüche definieren vorteilhafte Weiterbildungen.

Zunächst und im Wesentlichen wird vorgeschlagen, dass in einer Anzahl von Messintervallen, die zeitlich hintereinander liegen können, die unmittelbar zeitlich hintereinander liegen, die mit zeitlichen Abständen hintereinander liegen können und/oder sich auch teilweise überlappen können, jeweils zumindest zwei Messwertpaare gemessen werden, wobei jedes Messwertpaar einen mit einer optischen Messeinrichtung gemessenen Emissionswert und einen mit derselben oder einer anderen optischen Messeinrichtung gemessenen Reflektanzwert beinhaltet. Bevorzugt werden innerhalb eines Messintervalls so viele, mindestens zwei oder drei, Messwertpaare gemessen, dass durch eine Punktwolke der über die Reflektanzwerte abgetragenen Emissionswerte eine Ausgleichsgerade gelegt werden kann. Des Weiteren wird vorgeschlagen, dass zu jedem der Messintervalle ein temperaturabhängiger Faktor berechnet wird. Es kann vorgesehen sein, dass sich die mit den zuvor beschriebenen Maßnahmen nicht messbare "wahre Temperatur" des Substrates während der gesamten Messzeit, die sich über die Dauer der Anzahl der Messintervalle erstreckt, ändert. Die Änderung kann bis zu 20°C oder mehr betragen. Die Anzahl der Zeitintervalle kann so gewählt sein, dass sich während eines Messintervalls die "wahre Temperatur" des Substrates nur geringfügig ändert, beispielsweise um maximal 2°C, so dass die Temperatur innerhalb jedes Zeitintervalls als quasi konstant angesehen werden kann. Dies hat zur Folge, dass sich die zu jedem Messintervall berechneten Faktoren voneinander unterscheiden. Bei einem CVD-Reaktor, der einen sich um eine Drehachse drehenden Suszeptor aufweist, auf dem die Substrate um die Drehachse herum angeordnet sind, wandert ein bestimmtes Substrat in zeitlichen Abständen von 5 bis 20 Sekunden unter einer Messstelle hindurch, an der das Messwertpaar gemessen wird. Die Dauer eines Messintervalls ist mindestens so groß, dass das Substrat zweimal unter der Messstelle hindurch wandert. Bevorzugt wandert das Substrat im Messintervall mehr als zweimal unter der Messstelle hindurch. Auf dem Substrat werden Schichten abgeschieden, die die Eigenschaften besitzen, dass sich während des Abscheidens aufgrund von Reflektionen innerhalb der Schicht der Emissionswert und der Reflektanzwert periodisch ändern. Die zeitliche Periodenlänge ist bevorzugt wesentlich größer als das Messintervall. Das Messintervall kann kleiner als ein Viertel oder ein Zehntel der Periodenlänge sein. Die gesamte Messzeit, also die Summe der Zeiten der Messintervalle ist bevorzugt größer als ein Viertel der Periodenlänge. Besonders bevorzugt ist die gesamte Messzeit größer als eine Periodenlänge. Die Messzeit kann auch größer als mehrere Periodenlängen sein. Die gesamte Messzeit kann dann die Summe der Zeiten aller Messintervalle sein.

Bei dem Verfahren wird für das genannte relativ kurze Messintervall von einer oder mehreren Umdrehungen (Zeitintervall $t_i$), eine erste Berechnung der emissivitäts-korrigierten Wafertemperatur $T_i$ durchgeführt. Diese Berechnung kann in mehreren aufeinander folgenden Messintervallen $t_i$, $t_{i+1}$, $t_{i+2}$, ... wiederholt durchgeführt werden. Hierbei können sich die Messintervalle auch überschneiden. Für die Berechnung werden die gemessenen Signale $U_E$ und $U_R$ sowie Gleichung (3) herangezogen. Das Ergebnis dieser ersten Berechnung ist für jedes Messintervall i ein Normierungsfaktor

$C_i(T_i)$, die emissivitätskorrigierten Wafertemperatur $T_i$ und ein Schätzwert für den Korrekturwert (Streulichtkalibrierparameter) $\gamma_i$ für jedes der kurzen Messintervalle i, $C_i(T_i)$ und $\gamma_i$ können dabei aus der Auftragung der Messsignale $U_E$ als Funktion von $U_R$ wie in Gleichung (3) durch einfache lineare Regression (Geradenfit) oder durch ein anderes, geeignetes beispielsweise Regressions- oder Optimierungsverfahren ermittelt werden. Die Wafertemperatur $T_i$ ergibt sich aus $C_i(T_i)$ gemäß Gleichung (4).

Aus diesen Werten kann in einem nächsten Schritt der für die möglichst genaue Streulichtkompensation erforderliche Wert des Korrekturwertes (Kalibrierparameters) $\gamma_k$ über alle Messintervalle i ermittelt werden. Die entstehende hohe Ungenauigkeit bei der Ermittlung von $\gamma_i$ in den kurzen Messintervallen i, in denen die Temperatur als hinreichend konstant angenommen wird aber eine zu geringe Anzahl von Datenpunkten vorliegt, wird dadurch ausgeglichen, dass die Berechnung von $\gamma_k$ in einem zweiten Rechenschritt mithilfe von Daten über ein deutlich längeres Zeitintervall $t_k > t_i$ erfolgt, wobei $t_k$ mindestens einer Viertel Periode der Oszillationen entspricht, besser jedoch mehreren vollen Perioden. Dieser zweite Rechenschritt, der der Ermittlung des Streulichtkorrekturparameters $\gamma_k$ dient, kann folgende Ausführungsformen haben:

Gemäß einer ersten Variante der Erfindung werden die temperaturabhängigen Faktoren als Normierungsfaktoren verwendet. Dabei wird eine Normierung der $U_E$ Werte mit den Normierungsfaktoren $C_i(T_i)$ für jedes der relativ kurzen Zeitintervalle $t_i$ mit konstant angenommener Wafertemperatur vorgenommen, um temperaturunabhängige Werte $U'_E$ innerhalb des längeren Zeitintervalls $t_k$ zu erhalten. Aus der Gleichung (3) ergibt sich dadurch für die temperaturunabhängigen Werte $U'_E$:

$$U'_{E,i} \quad = \frac{U_{E,i}}{C_i(T_i)} = 1 - \alpha \cdot \gamma_k \cdot U_{R,i} \qquad (5)$$

Aus der Auftragung von $U'_E$ über $U_R$ für das längere Zeitintervall $t_k$ wird $\gamma_k$ durch einfache lineare Regression oder durch ein anderes, geeignetes Regressions- oder Optimierungsverfahren, wie es beispielsweise von Breiland an der oben genannten Stelle beschrieben wird, ermittelt werden.

Zu jedem der vielen Messintervalle i wird jeweils über eine Messzeit $t_i$ eine gewisse Anzahl von Messwertpaaren jeweils für einen Reflektanzwert $U_R$ und einen Emissionswert $U_E$ gemessen. In der oben beschriebenen Weise wird dann für jedes der Messintervalle i der Faktor $C_i(T_i)$ bestimmt. Dies in die Gleichung (5) eingesetzt, ergibt ein Gleichungssystem, dessen Anzahl an Gleichungen der Anzahl der Messungen im Messintervalle i entspricht. Das Gleichungssystem hat die beiden Kalibrierfaktoren $\alpha$ und y, von denen $\gamma$ unbekannt ist, und über die die Regression ermittelt werden kann.

Gemäß einer zweiten Variante der Erfindung wird die Temperatur $T_i$ aus den Werten von $C_i(T_i)$ berechnet und ein Fit an diesem Temperaturverlauf durchgeführt. $\gamma_k$ wird solange angepasst, bis der resultierende Temperaturmesswert möglichst genau dem Temperaturverlauf aus den $C_i(T_i)$ entspricht.

Zunächst werden in der zuvor beschriebenen Weise für jedes Messintervall i die Faktoren $C_i(T_i)$ bestimmt. Aus den Faktoren $C_i(T_i)$ können dann die Temperaturwerte bestimmt werden. Damit ist für jedes Messintervall i eine Temperatur bestimmt worden. Aus der Gleichung (2) lässt sich eine Temperatur T' für jeden Messpunkt ermitteln. Die Temperaturen T' weichen von den Temperaturen $T_i$ ab. Indem diese Abweichungen durch Variationen des Wertes $\gamma$ minimiert werden, lässt sich der Korrekturwert $\gamma$ ermitteln.

Gemäß einer dritten Variante der Erfindung wird eine Mittelung über die Schätzwerte $\gamma_i$ für die relativ kürzeren Intervalle $t_i$ über das längere Intervall $t_k$ durchgeführt.

Das erfindungsgemäße Verfahren ermöglicht insbesondere eine fortlaufende Korrektur oder Anpassung des Korrekturwertes während des Abscheidens der Schicht. Es ist insbesondere vorgesehen, dass mit jedem neuen Messwertpaar eine Anpassung des Korrekturwertes vorgenommen wird. Die Messdauer bzw. die Anzahl der für die Bestimmung des Korrekturwertes verwendeten Messintervalle kann konstant gehalten werden oder innerhalb vorgegebener Grenzen variieren. Es ergibt sich somit ein mit der Zeit wanderndes Intervall, während dessen die zur Bestimmung des Korrekturwertes erforderlichen Messwertpaare ermittelt werden. Die Dauer des Intervalls, also die Messdauer, kann ein konstanter Wert sein. Das Ergebnis des zuvor beschriebenen Verfahrens ist eine berechnete Temperatur. Diese Temperatur kann als Istwert verwendet werden, um die Substrattemperatur mit einem Regelkreis und einer Temperiereinrichtung, bspw. einer Heizung, gegen einen Sollwert zu regeln.

Die Erfindung betrifft darüber hinaus eine optische Messeinrichtung, mit der die Messwertpaare ermittelbar sind, die eine Recheneinrichtung aufweist, mit der der Korrekturwert berechnet werden kann.

Die Erfindung betrifft darüber hinaus eine Vorrichtung zur Durchführung des Verfahrens, beispielsweise einen CVD-Reaktor mit einem in einem Reaktorgehäuse angeordneten Gaseinlassorgan, durch welches ein Prozessgas, das aus einem Hydrid der III-Hauptgruppe und aus einer metallorganischen Verbindung der IV-Hauptgruppe bestehen kann, in eine Prozesskammer eingespeist werden kann. Das Gaseinlassorgan kann ein zentrales Gaseinlassorgan sein, um das sich ein Suszeptor dreht. Das Gaseinlassorgan kann aber auch als shower head ausgebildet sein. Der Suszeptor, der den Boden der Prozesskammer bildet, kann von einer Heizeinrichtung beheizt werden. Hierdurch wird der Suszeptor auf eine Prozesstemperatur gebracht. Der Suszeptor kann Taschen aufweisen, in denen jeweils ein Substrathalter gelagert ist, der auf einem Gaskissen lagert. Mit dem das Gaskissen erzeugenden Gasfluss kann der Substrathalter in eine Drehung gebracht werden. Die Höhe des Gaskissens kann zur Veränderung des Wärmeflusses vom Suszeptor zum Substrathalter variiert werden. Die Heizeinrichtung und die Mittel zur Variierung der Spalthöhe zwischen Suszeptor und Substrathalter bilden eine Temperiereinrichtung, die von einer Recheneinrichtung, die eine Regeleinrichtung umfassen kann, geregelt wird, um eine Substrattemperatur gegen einen Sollwert zu regeln. Zur Bestimmung eines Ist-Wertes der Substrattemperatur können ein oder mehrere optische Messeinrichtungen vorgesehen sein, mit denen Emissionswerte und Reflektanzwerte gemessen werden können. Erfindungsgemäß ist die Recheneinrichtung derart programmiert, dass ein Korrekturwert bestimmt wird, mit dem aus den Messwertpaaren ein Ist-Wert der Substrattemperatur nach dem zuvor beschriebenen Verfahren berechenbar ist.

Der Korrekturwert ergibt sich bevorzugt aus einer festgelegten Anzahl von Messwertpaaren. Wird in die Menge der Messwertpaare ein neuer Messwert aufgenommen, wird das älteste Messwertpaar verworfen, so dass der Korrekturwert bevorzugt nur aus den jüngsten Messwertpaaren berechnet wird.

**Kurze Beschreibung der Zeichnungen**

Ein Ausführungsbeispiel des Verfahrens wird nachfolgend anhand beigefügter Figuren im Detail erläutert. Es zeigen:

Fig. 1 schematisch eine Vorrichtung zur Durchführung des Verfahrens;

Fig. 2 schematisch den Schnitt gemäß der Linie II - II in Fig. 1 auf einem Suszeptor 4, auf dem Substrate 7 angeordnet sind und Messstellen 13, mit denen mittels einer Reflektanz-Messeinrichtung 11 und einer Emissionswert-Messeinrichtung 10 Emissionswerte $U_E$ und Reflektanzwerte $U_R$ gemessen werden können;

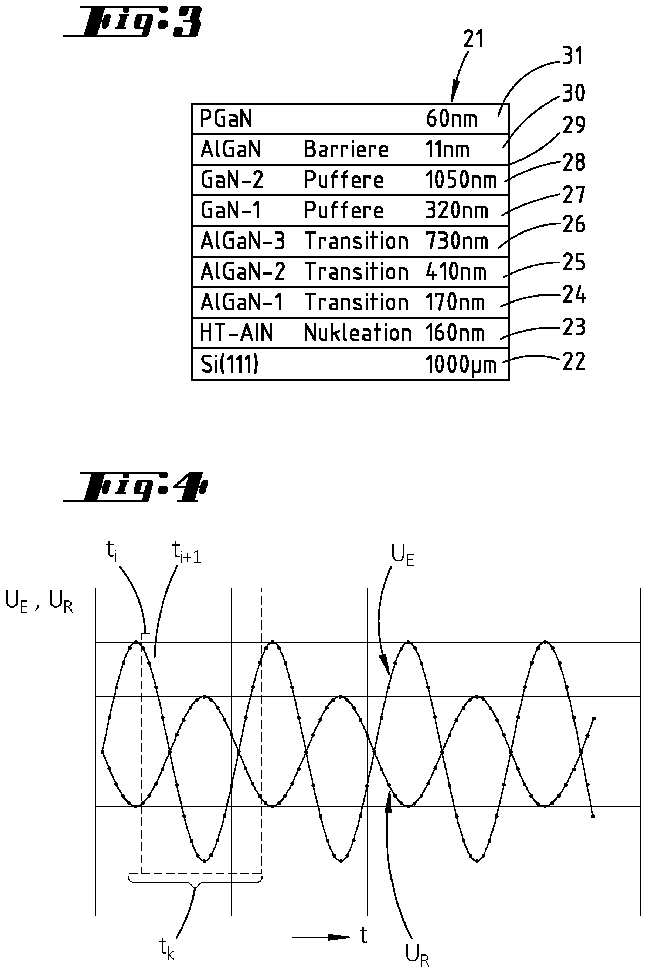

Fig. 3 schematisch den Aufbau einer Mehrschichtstruktur 21 auf einem Siliziumsubstrat 22;

Fig. 4 den zeitlichen Verlauf des Messwertes der Emission $U_E$ und des Messwertes der Reflektanz $U_R$ über die Zeit t, wobei mit $t_k$ eine gesamte Messzeit bezeichnet ist, über der in mehreren Messintervallen i mit einer Dauer $t_i$ Messwertpaare bestehend jeweils aus einem Emissionswert $U_E$ und einem Reflektanzwert $U_R$ gemessen werden;

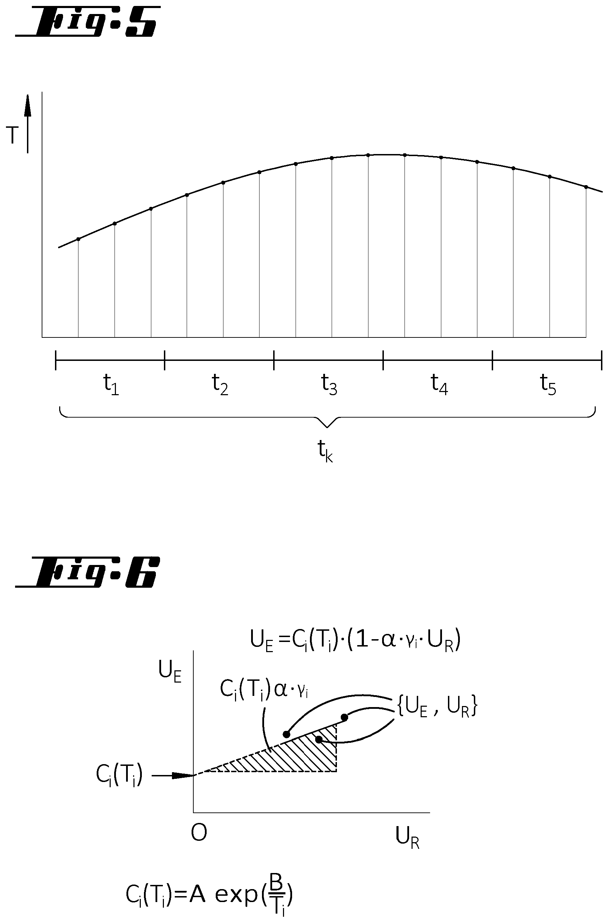

Fig. 5 als gestrichelte Linie beispielhaft den zeitlichen Verlauf einer "wahren Temperatur" über die gesamte Mess-zeit $t_k$, die der Gesamtdauer von fünf Messintervallen $t_1$ bis $t_5$ entspricht;

Fig. 6 schematisch ein Verfahren, mit dem aus mindestens zwei, im Ausführungsbeispiel drei Messwertpaaren $\{U_E, U_R\}$ eines Messintervalls i durch Abtrag der Emissionswerte $U_E$ über die Reflektanzwerte $U_R$ und Ziehen einer Ausgleichsgeraden durch die Messpunkte ein temperaturabhängiger Faktor $C_i (T_i)$ gewonnen wird, wozu der Schnittpunkt der Ausgleichsgerade mit der durch den Nullpunkt der Abszisse gelegten Ordinate ermittelt wird, die Parameter $\alpha$ und $\gamma$ ergeben sich aus dem dort schraffiert dargestellten Steigungs-dreieck, da $\alpha$ bekannt ist und sich $C_i (T_i)$ durch den $\gamma$-Achsenabstand ergibt, kann $\gamma$ berechnet werden;

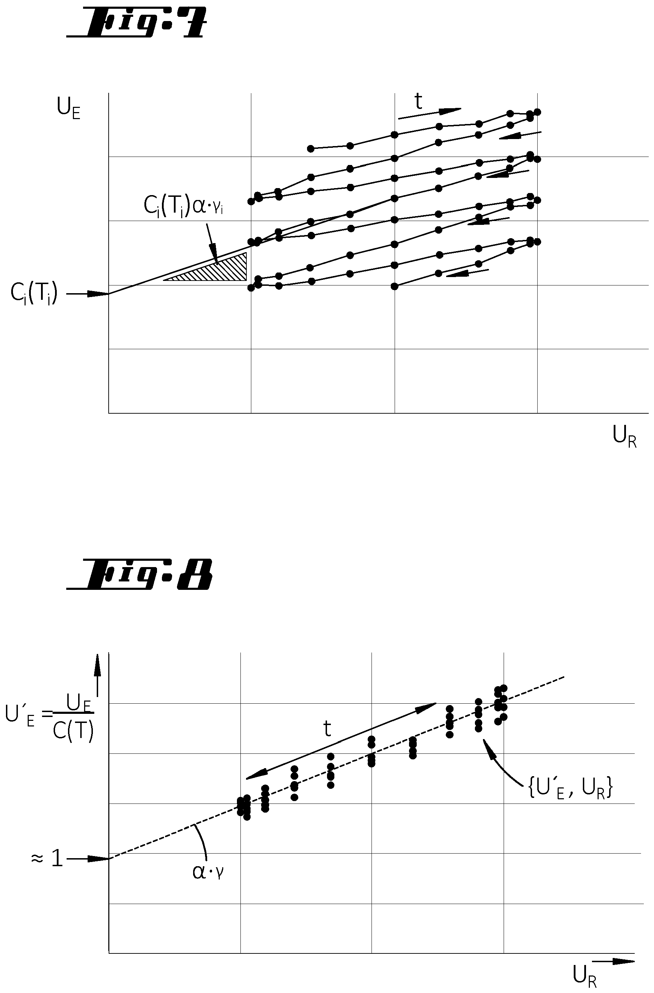

Fig. 7 zur Verdeutlichung eines ersten Ausführungsbeispiels schematisch eine Darstellung gemäß Fig. 6, bei der sämtliche Messwerte aller Messintervalle i in einem Diagramm dargestellt sind, zur Verdeutlichung, dass durch die Messpunkte verschiedener Messintervalle i zu Ausgleichsgeraden mit verschiedenen Steigungen und verschiedenen Schnittpunkten mit der Ordinate führen, der Parameter $\alpha$ ergibt sich aus dem dort schraffiert dargestellten Steigungsdreieck;

Fig. 8 die Darstellung gemäß Fig. 6, bei der sämtliche Messwerte aller Messintervalle in einem Diagramm dargestellt sind, wobei jedoch anstelle eines Emissionswertes $U_E$ ein normierter Emissionswert $U'_E$ verwendet wird, der durch eine Division des gemessenen Emissionswerts $U_E$ mit einem Normierungsfaktor $C_i(T_i)$ be-rechnet wird, und durch die so gewonnen Punktwolke eine Ausgleichsgerade gezogen wird, die bei dem Wert 1 die Ordinate schneidet und deren Steigung das Produkt eines Kalibrierparameters $\alpha$ mit einem Kor-rekturwert $\gamma$ ist;

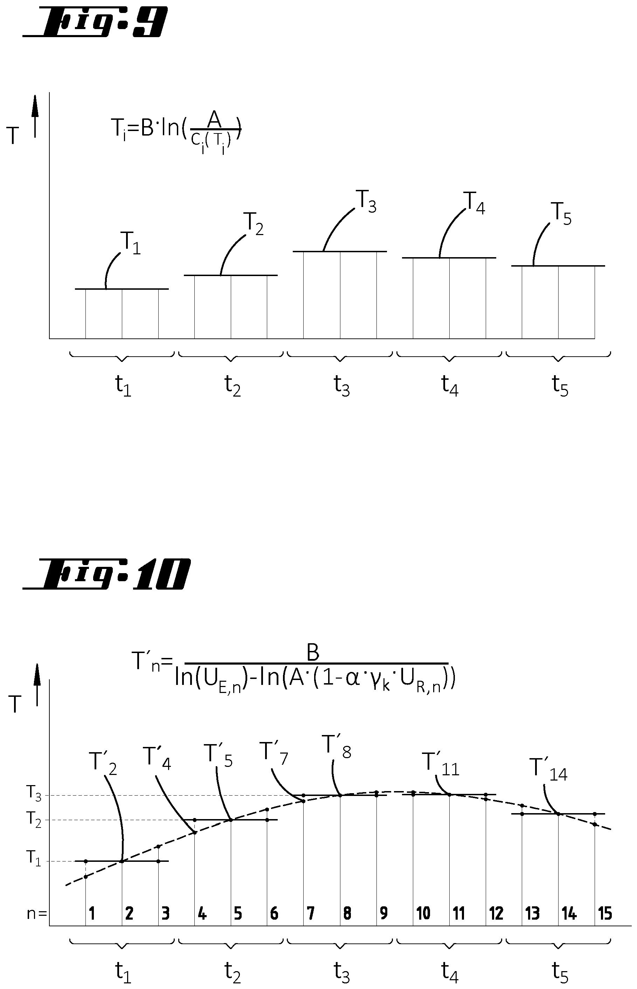

Fig. 9 zur Verdeutlichung eines zweiten Ausführungsbeispiels eine Darstellung gemäß Fig. 5, wobei jedoch anstelle des Verlaufs der "wahren Temperatur" des Substrates die gemäß Fig. 6 für jedes Messintervall i aus den Faktoren $C_i (T_i)$ berechneten Temperaturen $T_i$ dargestellt sind;

Fig. 10     eine Darstellung gemäß Fig. 9, wobei in der Mitte jedes Zeitintervalls der berechneten Temperatur $T_i$ zuge-ordnet wird und durch die berechneten Temperaturen $T_i$ eine Verbindungskurve dargestellt ist, die auch aus einem Polygon bestehen kann, und die Abstände der zu jedem Messpunkt n berechneten Tempera- tur $T'_n$ zur berechneten Temperatur $T_i$ des Messintervalls i dargestellt sind, die in einem Optimierungsverfahren zu minimieren sind;

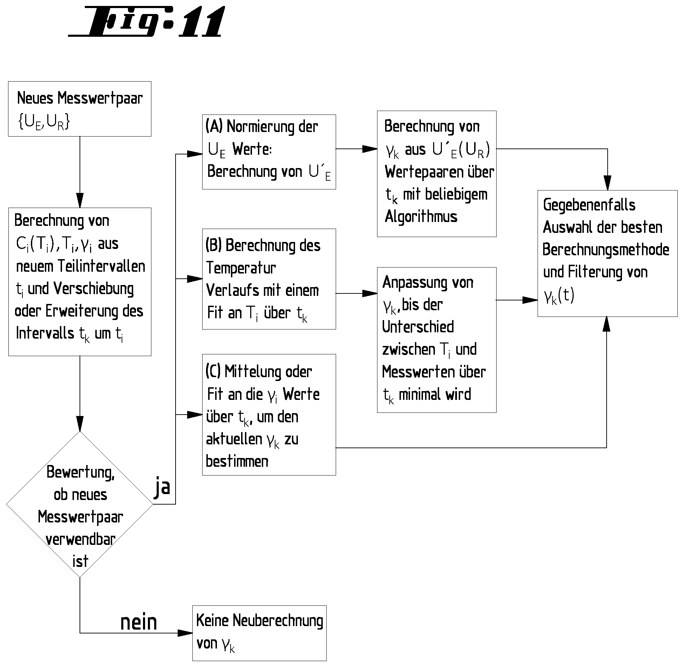

Fig. 11     ein Flussdiagramm des Verfahrens.

**Beschreibung der Ausführungsformen**

Der in den Figuren 1 und 2 dargestellte CVD-Reaktor besitzt ein Reaktorgehäuse 1, eine darin angeordnete Heizeinrichtung 5, einen oberhalb der Heizeinrichtung 5 angeordneten Suszeptor 4 und ein Gaseinlassorgan 2 zum Einleiten von beispielsweise TMGa, TMA1, $NH_3$, $AsH_3$, $PH_3$ und $H_2$. Der Suszeptor 4 wird mit Hilfe einer Drehantriebseinrichtung 14 um eine vertikale Drehachse A drehangetrieben. Eine Antriebswelle 9 ist hierzu einerseits mit der Drehantriebseinrichtung 14 und andererseits mit der Unterseite des Suszeptors 5 verbunden.
Auf der von der Heizeinrichtung 5 wegweisenden horizontalen Oberfläche des Suszeptors 5 liegen Substrate 7. Es sind Substrathalter 6 vorgesehen, auf denen die Substrate 7 liegen. Die Substrate 7 liegen radial außerhalb der Drehachse A und werden von Substrataufnahmen in Position gehalten.
Es können zwei Messeinrichtungen vorgesehen sein. Eine Emissions-Messeinrichtung 12 kann von einem Pyrometer gebildet sein. Eine Reflektanz-Messeinrichtung 11 kann ebenfalls von einem Pyrometer ausgebildet sein. Es kann ein Strahlteiler 10 vorgesehen sein, mit dem ein Eingangsstrahl auf die beiden Messeinrichtungen 12, 11 aufgeteilt werden kann. Der Strahlengang tritt an einer Messstelle 13 auf das Substrat 7. Die Figur 2 deutet an, dass die Messstelle 13 während einer Drehung des Suszeptors 4 über sämtliche der Substrate 7 wandert.
Die Figur 3 zeigt eine Mehrschichtstruktur 21, die in mehreren aufeinanderfolgenden Beschichtungsschritten in einem Beschichtungsprozess hintereinander abgeschieden werden. Auf das Siliziumsubstrat 22 wird zunächst eine Nukleationsschicht 23 aus AlN oder InN abgeschieden. Auf die Nukleationsschicht 23 wird sodann eine erste AlGaN-Schicht 24, darauf eine zweite AlGaN-Schicht 25 und darauf eine dritte AlGaN-Schicht 26 abgeschieden. Die drei AlGaN-Schichten 24 bis 26 bilden Übergangsschichten aus. Der Aluminiumgehalt der Übergangsschichten kann schrittweise abnehmen.
Auf die Übergangsschichten 24 bis 26 wird sodann eine erste Bufferschicht 27 aus GaN abgeschieden. Die Schicht kann C-dotiert sein. Auf die erste Bufferschicht 27 wird sodann eine zweite Bufferschicht 28 ebenfalls aus GaN abgeschieden, die undotiert sein kann.
Beim Abscheiden einer der Schichten 23 bis 31 auf dem Substrat 22 werden mit Hilfe der Reflektanzwert-Messeinrichtung 11 und der Emissionswert-Messeinrichtung 12 an der zur Prozesskammer 8 weisenden Oberseite des Substrates 7 jeweils an einer Messstelle 13 Messwertpaare $\{U_{E,n}, U_{R,n}\}$ gemessen. Diese Messwertpaare werden in einer Speichereinrichtung einer Recheneinrichtung 15 gespeichert. Die beiden Messeinrichtungen 11 und 12 können in einem gemeinsamen Messkopf angeordnet und die so gestaltete optische Messvorrichtung kann eine Recheneinrichtung 15 aufweisen. Die Recheneinrichtung 15 kann in einem außerhalb des Reaktorgehäuses angeordneten Gehäuse untergebracht sein. Dort kann auch Lichtquelle untergebracht sein, deren Licht mit einem Lichtleiter zum Messkopf geführt wird. Der Messkopf kann darüber hinaus eine weitere Lichtleitung aufweisen, mit der Licht zum Gehäuse geleitet wird, wo eine optische Messeinrichtung angeordnet ist, die sowohl die Funktion der Reflektanzwert-Messeinrichtung als auch die der Emissionswert-Messeinrichtung ausübt.
Die aktuelle Temperatur $T_C$ des Substrates 7 kann gemäß dem Planck'schen Strahlungsgesetz ermittelt werden. Der Einfachheit halber wird im Folgenden hierzu die Wiensche Näherung verwendet:

$$U_E = \varepsilon \cdot A \cdot e^{\frac{B}{T}} \qquad (1)$$

wobei

$$\varepsilon = 1 - \alpha \cdot \gamma \cdot U_R.$$

Die Figur 4 zeigt schematisch den zeitlichen Verlauf von sowohl dem Emissionswert $U_E$ als auch den Reflektanzwert $U_R$. Aufgrund der Reflektionen innerhalb der abgeschiedenen Schicht oszilliert das Messsignal mit steigender Schichtdicke, also mit fortlaufender Zeit t.
Um auf Streulichteffekte oder dergleichen zurückzuführende Restoszillationen zu kompensieren, wird der oben genannte Korrekturwert $\gamma$ eingefügt, so dass sich der folgende Zusammenhang ergibt:

$$U_E = A \cdot e^{\frac{B}{T}} \cdot (1 - \alpha \cdot \gamma \cdot U_R) \qquad (2),$$

$$U_E = C(T) - C(T) \cdot \alpha \cdot \gamma \cdot U_R \qquad (3)$$

wobei im Folgenden der folgende Faktor eine erfindungsrelevante Rolle spielt:

$$C(T) = A \cdot e^{\frac{B}{T}} \qquad (4).$$

Beim erfindungsgemäßen Verfahren werden während des Abscheidens einer der in der Figur 3 dargestellten Schichten und insbesondere einer der Schichten 23 bis 28 während einer Zeit $t_k$ Messwertpaare gewonnen. Die Figur 5 zeigt beispielhaft einen zeitlich nicht konstanten Verlauf einer "wahren Temperatur" des Substrates, die leicht ansteigt bzw. zu einer späteren Zeit leicht abfällt. Die Gesamtzeit $t_k$, während der die Messung durchgeführt wird, wird in mehrere Messintervalle i mit Messzeiten $t_i$, im Ausführungsbeispiel $t_1$, $t_2$, $t_3$, $t_4$ und $t_5$ aufgeteilt. Während jedem Messintervall i beziehungsweise den Messzeiten $t_1$, $t_2$, $t_3$, $t_4$ und $t_5$ werden jeweils drei Messwertpaare $\{U_{E,i}, U_{R,i}\}$ gewonnen, wobei jedes Messwertpaar einen Emissionswert $U_E$ und einen Reflektanzwert $U_R$ beinhaltet.

Die Figur 6 zeigt eine Darstellung, in der die Messwertpaare $\{U_E, U_R\}$ eines der Messintervalle $t_i$ als Messpunkte in einem Koordinatensystem $U_E$ über $U_R$ dargestellt sind. Aus der Gleichung 2 ist zu ersehen, dass der Korrekturwert $\gamma$ den unbekannten Beitrag zur Steigung einer Geraden verkörpert. Aus der Gleichung 3 ist zu entnehmen, dass der Faktor C (T) durch den Schnittpunkt der Ausgleichsgeraden durch die Ordinate des Koordinatensystems ermittelbar ist.

Durch eine lineare Regression kann somit zu jedem Messintervall i ein dem Messintervall i zugeordneter Korrekturwert $\gamma_i$ und Faktor $C_i$ gefunden werden. Aus dem Faktor $C_i$ kann wiederum nach der Gleichung 4 eine Temperatur $T_i$ jedes Messintervalls i gewonnen werden (siehe Figuren 9 und 10).

Würde man, wie in der Figur 7 gezeigt, alle Messpunkte sämtlicher Messintervalle i in einem Diagramm darstellen, würden sich Ausgleichsgeraden mit verschiedenen Steigungen und Schnittpunkten der Ordinate ausbilden. Die Figur 7 zeigt, dass es zu jedem der Messintervalle i aufgrund des in der Figur 5 dargestellten Temperaturverlaufs individuelle Korrekturwerte $\gamma_i$ und Faktoren $C_i$ gibt.

Um die Zusammenhänge der Emissionswerte $U_E$ und Reflektanzwerte $U_R$ in einer gemeinsamen Darstellung auswerten zu können, wird gemäß einem ersten Ausführungsbeispiel der Erfindung einer Normierung des Emissionswertes $U_E$ vorgenommen, indem der gemessene Emissionswert $U_E$ durch den Faktor $C_i$ des jeweiligen Messintervalls i dividiert wird. Die so gewonnenen normierten Emissionswerte $U'_{E,i}$ aller Messwertpaare sind in der Figur 8 dargestellt. Der formale Zusammenhang zwischen dem normierten Emissionswert $U'_E$, einem einheitlichen Korrekturwert $\gamma$ und den Reflektanzwerten $U_{R,n}$ sowie den Emissionswerten $U_{E,n}$ ist der folgende:

$$U'_E = \frac{U_{E,n}}{C_i(T_i)} = (1 - \alpha \cdot \gamma \cdot U_{R,n}) \qquad (5a).$$

Durch die in der Figur 8 dargestellte Punktwolke kann somit der sich aus der Gleichung 5a ergebende lineare Zusammenhang dargestellt werden. Aus der Steigung der Ausgleichsgeraden kann der Korrekturwert $\gamma$ ermittelt werden, der gemäß Figur 4 aus Messwerten gewonnen wird, die über zumindest eine Periodenlänge aufgenommen werden, die aber in mehrere Messintervalle aufgeteilt ist.

Dieser Korrekturwert $\gamma$ wird verwendet, um aus den Beziehungen gemäß der Gleichung 2 oder der Gleichung 3 die Temperaturen T zu berechnen, die bei der Regelung als Istwert einer Substrattemperatur verwendet werden, um beispielsweise eine der in der Figur 3 dargestellten Schichten abzuscheiden, wobei $U_R$ und $U_E$ jeweils die aktuellen Werte des Emissionswertes und des Reflektanzwertes sind.

Ein zweites Ausführungsbeispiel der Erfindung wird anhand der Figuren 9 und 10 erläutert.

Die Figur 9 zeigt eine Darstellung ähnlich der Figur 5, wobei jedoch anstelle der "wahren Temperatur", die technisch nur schwer gemessen werden kann, die Temperaturen $T_i$ aufgetragen sind, die sich aus dem zur Figur 6 erläuterten Verfahrensschritt berechnen lassen. Die Temperaturen $T_i$ werden direkt aus dem Faktor $C_i$ wie folgt bestimmt:

$$T_i = B/\ln\left(\frac{C_i(T_i)}{A}\right) \qquad (6).$$

Im Anschluss daran wird durch die Temperaturen $T_i$ etwa durch die zeitlichen Mittelpunkte der Messintervalle i eine Ausgleichskurve gezogen. In der Figur 10 ist diese Ausgleichskurve als gestrichelte Gerade zwischen den Mittelpunkten der Messintervalle i dargestellt. Es ist ersichtlich, dass die mit $C_i(T_i)$ berechneten mittleren Temperaturen $T_i$ der

Messintervalle i von den individuell nach der folgenden Gleichung berechneten Temperaturen T'$_n$ abweichen.

$$T'_n = \frac{B}{\ln(U_{E,n}) - \ln\left(A \cdot (1 - \alpha \cdot \gamma \cdot U_{R,n})\right)} \qquad (7)$$

Durch eine Optimierungsrechnung beispielsweise wie folgt:

$$\frac{d}{d\gamma} \sum (T'_n - T_i)^2 \qquad (8)$$

kann ein Wert für den Korrekturwert $\gamma$ berechnet werden, indem der Korrekturwert $\gamma$ in Gleichung 7 solange variiert wird, bis der resultierende Temperaturmesswert T'$_i$ möglichst genau dem Temperaturverlauf aus C$_i$ (T$_i$) entspricht.

Bei dem in der Figur 10 dargestellten Ausführungsbeispiel kann auch ein Polygon als Ausgleichskurve durch die berechneten Temperaturen T$_i$ gelegt werden. In anderen Ausführungsbeispielen kann eine exponentielle Kurve, eine sinusförmige Kurve oder eine Kombination derartiger Kurven verwendet werden.

Gemäß einem dritten Ausführungsbeispiel der Erfindung werden zunächst wie anhand der Figur 6 oben beschrieben zu jedem Messintervall i individuelle Korrekturwerte $\gamma_i$ berechnet. Aus diesen Korrekturwerten $\gamma_i$ wird dann ein Mittelwert berechnet.

Weitere Ausführungsformen im Zusammenhang mit den zuvor beschriebenen Methoden des ersten, zweiten oder dritten Ausführungsbeispiels können die folgenden Eigenschaften aufweisen:

Neben der Berechnung von C$_i$ (T$_i$) und T$_i$ aus einem Zeitintervall t$_i$ für einen bestimmten Datenpunkt U$_{Ei}$ (U$_{Ri}$), können C$_i$ (T$_i$) und T$_i$ auch aus zwei oder mehr Zeitintervallen t$_i$, t$_{i+1}$,..., die vor und nach einem spezifischen Messwertpaar liegen, bestimmt werden. Die gültigen Werte C$_i$ (T$_i$) und T$_i$ sind dann die Mittelwerte aus der Berechnung über mehrere Zeitintervalle.

In einer bevorzugten Variante der Erfindung oder der Ausführungsbeispiele wird die Anzahl der Messintervalle oder die Messdauer konstant gehalten. Bei der Berechnung des Korrekturwertes $\gamma$ werden bei dieser Variante nur die jüngsten Messwertpaare verwendet. Wird die Menge der Messwertpaare um ein neues Messwertpaar ergänzt, wird das jeweils älteste Messwertpaar aus der Menge herausgenommen. Mit diesem Verfahren stellt sich ein mit der Zeit wanderndes Messfenster ein, während dessen die für den Korrekturwert benötigten Messwerte ermittelt werden. Mit jeder Messung wird der Korrekturwert $\gamma$ aktualisiert.

Darüber hinaus kann ein gleitender Fit durch alle C$_i$ (T$_i$) gelegt werden (eventuell mit einer Gewichtung auf die neuesten Messdaten), um eine möglichst genaue Ermittlung der Werte zu ermöglichen, die für die Berechnung von U'$_E$ genutzt werden. Dieser Fit kann je nach zu erwartender Art der Temperaturänderung linear, polynomisch, exponentiell, sinusförmig oder eine Kombination dieser Funktionen sein. Je nach Signalform kann die Auswahl der passenden Funktion auch automatisch erfolgen.

Um das Rauschen der Daten, die aus der Berechnung über die Zeitintervalle t$_i$ stammen, zu verringern, können besonders fehlerhafte Daten aussortiert werden.

Hier kann sowohl T$_i$ als auch $\gamma_i$ als Gütezahl verwendet werden.

i. T$_i$ kann mit der mittleren Temperatur im Zeitintervall t$_x$ mit t$_i$ > t$_x$ > t$_k$ (gegebenenfalls gemessen mit einem falschen $\gamma$ Wert) verglichen werden. Wenn die Differenz zu groß ist, zum Beispiel größer 10°C, dann wird der entsprechende Datenpunkt aussortiert und nicht für die Weiterberechnung verwendet. Der Temperaturvergleich kann auch mit der maximal gemessenen Temperatur im Zeitintervall t$_x$ erfolgen, die typischerweise näher an der realen Temperatur liegt als der Mittelwert.

ii. Aus Erfahrung ist in der Regel bekannt, in welchem Bereich $\gamma_k$ für eine bestimmte Anlage und einen bestimmten Prozess liegen kann. Zum Beispiel kann dies der Wertebereich 0,95 bis 0,98 sein. Wertepaare mit einem $\gamma_i$ außerhalb dieses Bereichs können aussortiert werden. Sollte kein Erfahrungswert vorliegen, kann der Vergleich zwischen dem klassisch berechneten $\gamma_{k,klass}$ ohne Beachtung von Temperaturänderungen und dem wie hier beschriebenen berechneten $\gamma_k$ den maximal erlaubten Offset $|\gamma_{k.klass.} - \gamma_k|$ von $\gamma_i$ liefern. Der erlaubte Offset kann auch ein Vielfaches von $|\gamma_{k.klass.} - \gamma_k|$ sein.

Bei der Durchführung eines Fits über das längere Zeitintervall t$_k$ können Werte mit besonders großer Abweichung aussortiert werden. Dies ist möglich bei dem ersten, zweiten und dritten Ausführungsbeispiel.

Daten von Datenpunkten mit minimaler und maximaler Reflektion (bzw. maximalem und minimalem Emissionssignal) können von der Berechnung ausgeschlossen werden. Aufgrund der geringen Änderung in der Reflektanz und Emissivität sind diese Datenpunkte besonders anfällig für Rauschen.

Eine weitere Möglichkeit, das Rauschen zu verbessern, ist die Nutzung mehrerer Messorte oder Messzonen (Figur 2). Allgemein muss eine Messzone hinreichend klein gewählt werden, da durch unterschiedliche Schichtdicken über einen Wafer hinweg die Restoszillation des Temperatursignals heraus gemittelt wird, das resultierende Signal aber fehlerhaft ist. Allerdings kann die $\gamma_k$ Berechnung über mehrere Messzonen oder Orte gleichzeitig erfolgen. Diese Messzonen können auf demselben oder auf mehreren Wafern liegen. Vorteil ist auch, dass dadurch häufigere Neuberechnungen möglich sind als einmal pro Umdrehung. Da zu erwarten ist, dass $\gamma_k$ bei ausreichend homogenem Schichtwachstum konstant für alle Messzonen und Orte ist, kann als gültiger Wert der Mittelwert der $\gamma_k$ von den verschiedenen Messzonen genommen werden.

Wie beschrieben ist es möglich, dass sich $\gamma_k$ über den Prozess hinweg verändert. Mit der hier vorgestellten Methode kann $\gamma_k$ fortlaufend angepasst werden. Eine sprunghafte Änderung von $\gamma_k$ ist allerdings nicht zu erwarten. Daher kann mit einer geeigneten Filter-methode (zum Beispiel ein Tiefpassfilter) die fortlaufende Änderung von $\gamma_k$ geglättet werden.

In der Methode des dritten Ausführungsbeispiels kann statt einer einfachen Mittelung auch ein kontinuierlicher Fit genutzt werden, um die Änderung von $\gamma_k$ vorherzusagen. Dieser Fit kann je nach zu erwartender Änderung linear, polynomisch, exponentiell, sinusförmig oder eine Kombination dieser Funktionen sein. Je nach Signalform kann die Auswahl der passenden Funktion auch automatisch erfolgen.

Dieses Vorgehen kann auch in den Methoden der ersten und zweiten Ausführungsbeispiele genutzt werden. Dabei wird $\gamma_k$ mit einer zeitabhängigen Funktion $\gamma_k$ (t) ersetzt.

i. Im Fall einer Temperaturstufe im Prozess oder einer Wachstumspause, muss dies in der zeitlichen Funktion $\gamma_k$ (t) berücksichtigt werden; zum Beispiel durch löschen der nicht zu verwendenden Werte und Verschiebung der Zeitachse, sodass keine Pause in den Daten mehr vorliegt.

Nach der Methode des ersten Ausführungsbeispiels ist der y-Achsenabschnitt des linearen Fits der Daten $U'_E$ ($U_R$) ideal gleich 1. Bei einer Abweichung größer eines zu definierenden Wertes kann der bestimmte Wert für $\gamma_k$ als ungültig erklärt werden. Dann ist der zuvor benutzte Wert für $\gamma_k$ weiter zu verwenden.

Es kann am Anfang des Prozesses, wenn noch nicht genügend Daten vorliegen, ein $\gamma_k$ vorgegeben werden. Dieser kann zum Beispiel aus Erfahrungswerten oder dem vorherigen Prozessergebnis stammen. Dieser Wert ist dann Grundlage für die Aussortierung von Daten, dient als Basis für einen Filter oder dient als Ausgangspunkt für einen Fit.

Im Falle einer starken Temperaturänderung (zum Beispiel zwischen zwei Schichten), können die Daten $U_E(U_R)$ nicht verwendet werden. Dies kann automatisch über das aussortieren der Datenpunkte geschehen oder manuell durch die Rezeptsteuerung bzw. durch Erkennen der Änderung des Temperatur Setpoints. Eine fortlaufende Berechnung von $\gamma_k$ ist mit Ausschluss dieser Daten mit den Daten vor und nach der Temperaturänderung möglich.

$\gamma_k$ kann auch nach allen drei Methoden gleichzeitig berechnet werden. Die Auswahl eines gültigen $\gamma_k$ kann nach den zuvor beschriebenen Methoden erfolgen. Bei mehreren gültigen Werten kann eine Mittelung oder eine vorher festgelegte Priorisierung der Methoden den Wert definieren.

Da sowohl $\gamma_i$ als auch $T_i$ (und damit $C(T_i)$) zeitlich veränderlich sein können, könnte auch eine iterative Funktion in der Methode des zweiten Ausführungsbeispiels genutzt werden, um den optimalen (zeitlichen) Verlauf von $\gamma_i$ und $T_i$ zu ermitteln. Aus diesem zeitlichen Verlauf ließe sich $\gamma_k$ dann ermitteln.

a. Das iterative Vorgehen kann so aussehen, dass nach jeder $\gamma_k$ oder $\gamma_k$ (t) Berechnung $T_i$ neuberechnet wird unter Berücksichtigung von $\gamma_k$ oder $\gamma_k$ (t).
b. Der Verlauf von $C(T_i)$ aus der Methode des zweiten Ausführungsbeispiels kann genutzt werden, um eine optimierte Berechnung nach der Methode des ersten oder des dritten Ausführungsbeispiels durchzuführen. Der $C(T_i)$ Verlauf wird dabei im linearen Fit mit berücksichtigt.

Die Länge des Zeitintervalls $t_k$ kann automatisch bestimmt werden, um genau eine oder ein Vielfaches der Oszillationsperiode abzubilden.

Aus dem Unterschied, je nachdem ob $U_E$ bzw. $U_R$ ansteigend oder absteigend ist (über eine ganze Oszillationsperiode hinweg), kann der Fehler der Steigung, der durch die Temperaturveränderung hervorgerufen wird, bestimmt werden. Dies erlaubt eine Korrektur der Berechnung in jedem $t_i$ Intervall.

Aus dem Unterschied zwischen $T_i$ und $T_{i+1}$ kann die Temperaturänderung abgeschätzt werden. Bei konstanter Temperaturänderung werden $T_i$ und $T_{i+1}$ in die gleiche Richtung verschoben sein, wenn die Berechnung nicht gerade im Umkehrpunkt von $U_E$ und $U_R$ erfolgt. Dies kann dann iterativ zur Korrektur bei der Berechnung von $T_i$ und $T_{i+1}$ genutzt werden.

## Liste der Bezugszeichen

| 1 | Reaktorgehäuse | 30 | Barrierenschicht |
|---|---|---|---|

(fortgesetzt)

| | | | |
|---|---|---|---|
| 2 | Gaseinlassorgan | 31 | Deckschicht |
| 3 | Gaszuleitung | | |
| 4 | Suszeptor | $\gamma$ | Korrekturwert |
| 5 | Heizeinrichtung | $\gamma_i$ | Korrekturwert eines Messintervalls |
| 6 | Substrathalter | | |
| 6' | Gaskissen | $\lambda$ | Wellenlänge |
| 7 | Substrat | $\alpha$ A | Kalibrierparameter |
| 8 | Prozesskammer | | Drehachse |
| 9 | Drehachse | $\alpha$ | Kalibrierparameter |
| 10 | Strahlteiler | A | Kalibierparameter |
| 11 | Reflektanzwert-Messeinrichtung | B | Kalibrierparameter |
| | | $U_E$ | Emissionswert |
| 12 | Emissionswert-Messeinrichtung | $U_E'$ | normierter Emissionswert |
| | | $U_R$ | Reflektanzwert |
| 13 | Messteile | $U_{E,n}$ | Emissionsmesswert |
| 14 | Drehantriebseinrichtung | $U_{R,n}$ | Reflektanzmesswert |
| 15 | Recheneinrichtung | $T_C$ | korrigierte Temperatur, Temperatur-Istwert |
| 21 | Mehrschichtstruktur | | |
| 22 | Substrat | $T_M$ | Messtemperatur |
| 23 | Nukleationsschicht | $T_S$ | Temperatur-Sollwert |
| 24 | Übergangsschicht | $t_i$ | Zeitintervall |
| 25 | Übergangsschicht | i | Index eines Messintervalls |
| 26 | Übergangsschicht | n | Index eines Messwertpaares |
| 27 | Bufferschicht | k | Anzahl der Messintervalle |
| 28 | Bufferschicht | $t_k$ | gesamte Messzeit |
| 29 | Grenzschicht, zweidimensionales Elektronengas | s | Sollwert |

**Patentansprüche**

1. Verfahren zum Beschichten eines Substrates (22) mit mindestens einer Schicht (23 bis 31), wobei während des Abscheidens der Schicht (23 bis 31) mit mindestens einer optischen Messeinrichtung (10, 11) an der Schicht (23 bis 31) mehrfach hintereinander Messwertpaare ($\{U_{E,n}, U_{R,n}\}$), die jeweils einen Emissionswert ($U_E$), der der bei einer Lichtwellenlänge gemessenen Strahlungsleistung entspricht und einen Reflektanzwert ($U_R$), der auch bei einer Lichtwellenlänge gemessen wird, beinhalten, ermittelt werden, wobei mit den Beziehungen

$$U_E = A \cdot e^{\frac{B}{T}} \cdot (1 - \alpha \cdot \gamma \cdot U_R) \qquad \text{und}$$

$U_E = C(T) - C(T) \cdot \alpha \cdot \gamma \cdot U_R$ aus den Messwertpaaren ($\{U_{E,n}, U_{R,n}\}$) Temperaturwerte ($T_C$) einer Substrattemperatur berechnet werden, wobei A,B: Kalibrierparameter, mit B < 0,
$\alpha$ ein Kalibrierparameter der Reflektanznormierung, der den Zusammenhang zwischen dem Messsignal ($U_R$) und der physikalischen Reflektanz R, mit $0 \leq R \leq 1$ herstellt,
$\gamma$ ein zu bestimmender Korrekturwert und

C(T) ein temperaturabhängiger Faktor mit $C(T) = A \cdot e^{\frac{B}{T}}$ sind,

**dadurch gekennzeichnet, dass** während einer Messdauer innerhalb einer Vielzahl (k) von Messintervallen ($t_i$) jeweils zumindest zwei Messwertpaare ($\{U_{E,n}, U_{R,n}\}$) gemessen werden und zu jedem der Messintervalle ($t_i$) ein temperaturabhängiger Faktor ($C_i(T_i)$) ermittelt wird,
der für die Berechnung des Korrekturwertes ($\gamma$) verwendet wird.

2. Verfahren nach Anspruch 1, **dadurch gekennzeichnet, dass** der Faktor ($C_i(T_i)$) durch eine Regression der über die Reflektanzwerte ($U_R$) abgetragenen Emissionswerte ($U_E$) je oder über ein Optimierungsverfahren gewonnen wird.

3. Verfahren nach einem der vorhergehenden Ansprüche, **dadurch gekennzeichnet, dass** von den in zumindest einigen der Messintervalle aufgenommenen Emissionswerten ($U_E$) durch Division mit dem jeweiligen Faktor ($C_i(T_i)$) normierte Emissionswerte ($U'_E$) gebildet werden, mit

$$U'_E \;\; = \frac{U_{E,n}}{C_i(T_i)} = (1 - \;\alpha \cdot \gamma \cdot U_{R,n})$$

und durch eine Regression über die über die Reflektanzwerte ($U_R$) abgetragenen normierten Emissionswerte ($U'_E$) oder durch ein Optimierungsverfahren der Korrekturwert ($\gamma$) berechnet wird.

4. Verfahren nach Anspruch 4, **dadurch gekennzeichnet, dass** der Korrekturwert ($\gamma$) aus der Steigung einer Ausgleichsgeraden durch die normierten Emissionswerte ($U'_E$) gebildet wird.

5. Verfahren nach einem der Ansprüche 1 oder 2, **dadurch gekennzeichnet, dass** der Korrekturwert ($\gamma$) durch Anpassen von Temperaturwerten ($T_i$), die aus den Faktoren ($C_i(T_i)$) gewonnen werden mit

$$T_i = \mathrm{B}/\ln\left(\frac{C_i(T_i)}{A}\right) \;\; ,$$

an Temperaturwerte ($T'_i$), die aus den jeweiligen Messwertpaaren ($\{U_{E,n}, U_{R,n}\}$) berechnet werden

$$\mathrm{mit}\; T'_i = \frac{B}{\ln(U_{E,n}) \text{ - } \ln\left(\mathrm{A} \cdot (1 \text{-} \alpha \cdot \gamma \cdot U_{R,n})\right)} \;\; ,$$

gewonnen wird.

6. Verfahren nach einem der Ansprüche 1 oder 2, **dadurch gekennzeichnet, dass** zu jedem der Messintervalle ($t_i$) jeweils ein Korrekturwert ($\gamma_i$) ermittelt wird und von diesen Korrekturwerten ($\gamma_i$) über die Messdauer ein Mittelwert gebildet wird.

7. Verfahren nach einem der vorhergehenden Ansprüche, **dadurch gekennzeichnet, dass** sich der Emissionswert ($U_E$) und der Reflektanzwert ($U_R$) während des Abscheidens der Schicht (23 bis 31) oder einer aus mehreren Schichten (23 bis 31) bestehenden Mehrschichtstruktur (21) mit einer Periodenlänge periodisch ändert, wobei die zeitliche Dauer eines Messintervalls ($t_i$) geringer ist als ein Viertel oder ein Zehntel der Periodenlänge und dass die Gesamtdauer aller Messintervalle ($t_i$) größer ist als ein Viertel der Periodenlänge oder einem Mehrfachen der Periodenlänge.

8. Verfahren nach einem der vorhergehenden Ansprüche, **dadurch gekennzeichnet, dass** die Messdauer bzw. die Anzahl der für die Bestimmung des Korrekturwertes ($\gamma$) verwendeten Messintervalle ($t_i$) konstant gehalten wird und/oder dass sich der Korrekturwert ($\gamma$) mit der Zeit ändert.

9. Verfahren nach einem der vorhergehenden Ansprüche, **dadurch gekennzeichnet, dass** der Korrekturwert ($\gamma$) während des Abscheidens einer oder mehrerer Schichten auf dem Substrat fortlaufend optimiert wird und/ oder dass der Korrekturwert ($\gamma$) mit jedem neu ermittelten Messwertpaar ($\{U_{E,n}, U_{R,n}\}$) aktualisiert wird und/oder dass eine gleichbleibende Anzahl oder eine in einem vorbestimmten Bereich variierende Anzahl von Messwertpaaren zur Berechnung des Korrekturwertes ($\gamma$) verwendet wird.

10. Verfahren nach einem der vorhergehenden Ansprüche, **dadurch gekennzeichnet, dass** der Temperaturwert ($T_C$) ein Istwert ist, mit dem eine Temperiereinrichtung (5, 6') zum Temperieren des Substrates (22) gegen einen Sollwert (s) geregelt wird.

11. Messvorrichtung mit ein oder mehreren optischen Messeinrichtungen (10, 11), die eingerichtet sind, in einer Vorrichtung zum Abscheiden von Schichten mehrfach hintereinander Messwertpaare ($\{U_{E,n}, U_{R,n}\}$), die jeweils einen Emissionswert ($U_E$) und einen Reflektanzwert ($U_R$) beinhalten, zu ermitteln, und mit einer Recheneinrichtung (15), die in der Lage ist, unter Verwendung eines Korrekturwertes (γ) einen Istwert ($T_C$) einer Temperatur der Oberfläche der Schicht zu berechnen, **dadurch gekennzeichnet, dass** die Recheneinrichtung (15) derart programmiert ist, dass der Korrekturwert (γ) nach einem Verfahren gemäß einem der Ansprüche 1 bis 10 bestimmt wird.

12. Vorrichtung zum Abscheiden von Schichten auf einem Substrat mit einem in einem Reaktorgehäuse (1) angeordneten Gaseinlassorgan (2), durch welches Prozessgase in eine Prozesskammer (8) eingespeist werden, einem eine zur Prozesskammer (8) weisenden Fläche aufweisenden Suszeptor (4), der von einer Heizeinrichtung (5) beheizbar ist und auf dessen zur Prozesskammer (8) weisenden Fläche Substrate (22) anordbar sind, mit ein oder mehreren optischen Messeinrichtungen (10, 11) zur Messung eines Emissionswertes ($U_E$) und eines Reflektanzwertes ($U_R$) einer zur Prozesskammer (8) weisenden Breitseite des Substrates (22) und mit einer Regeleinrichtung zur Regelung der Temperatur des Substrates (22) unter Verwendung der von der mindestens einen optischen Messeinrichtung (10, 11) gemessenen Emissionswerte ($U_E$) und Reflektanzwerte ($U_R$), wobei eine Recheneinrichtung (15) einen Korrekturwert (γ) bestimmt und unter Verwendung des Korrekturwertes (γ) einen Istwert (Tc) der Temperatur berechnen kann, **dadurch gekennzeichnet, dass** die Messvorrichtung gemäß Anspruch 11 ausgebildet ist.

## Claims

1. Method for coating a substrate (22) with at least one layer (23 to 31), wherein, during deposition of the layer (23 to 31), at least one optical measuring device (10, 11) repeatedly determines successive measurement value pairs (($U_{E,n}$, $U_{R,n}$)) on the layer (23, to 31), each containing an emission value ($U_E$) corresponding to the radiation power measured at a light wavelength, and a reflectance value ($U_R$), which is also measured at a light wavelength,

   wherein temperature values ($T_C$) of a substrate temperature are calculated from the measurement value pairs (($U_{E,n}$, $U_{R,n}$)) with the equations

   $$U_E = A \cdot e^{\frac{B}{T}} \cdot ( 1 - \alpha \cdot \gamma \cdot U_R)$$

   and

   $$U_E = C(T) - C(T) \cdot \alpha \cdot \gamma \cdot U_R,$$

   wherein
   A,B: are calibration parameters in which B < 0,
   $\alpha$ is a reflectance normalisation calibration parameter which forms the relationship between the measurement signal ($U_R$) and the physical reflectance R, where $0 \leq R \leq 1$,
   $\gamma$ is a correction value to be determined and

   C(T) is a temperature-dependent factor for which $C(T) = A \cdot e^{\frac{B}{T}}$ ,

   **characterized in that** at least two measurement value pairs (($U_{E,n}$, $U_{R,n}$)) are each measured during a measurement duration within a multiplicity (k) of measurement intervals ($t_i$), and a temperature-dependent factor ($C_i(T_i)$) is determined for each of the measurement intervals ($t_i$), which factor is used for the calculation of the correction value (γ).

2. Method according to Claims 1, **characterized in that** the factor ($C_i(T_i)$) is obtained by a regression of the emission values ($U_E$) plotted over the reflectance values ($U_R$) for each or via an optimization process.

3. Method according to one of the preceding claims, **characterized in that** normalised emission values ($U'_E$) are formed from the emission values ($U_E$) recorded in at least some of the measurement intervals by dividing by the respective factor (Ci(Ti)),
   where

   $$U'_E = \frac{U_{E,n}}{C_i(T_i)} = (1 - \alpha \cdot \gamma \cdot U_{R,n})$$

and by regression via the normalised emission values ($U'_E$) plotted over the reflectance values ($U_R$) or by an optimization process of the correction value ($\gamma$).

4. Method according to Claim 4, **characterized in that** the correction value ($\gamma$) is formed from the gradient of a compensation curve through the normalised emission values ($U'_E$).

5. Method according to one of the claims 1 or 2, **characterized in that** the correction value ($\gamma$) is obtained by adapting temperature values ($T_i$), which are obtained from the factors ($C_i(T_i)$),

   where

$$T_i = B/\ln\left(\frac{C_i(T_i)}{A}\right) ,$$

   to temperature values ($T'_i$), which are calculated from the respective measurement value pairs ($\{U_{E,n}, U_{R,n}\}$) where

$$T'_i = \frac{B}{\ln(U_{E,n}) - \ln(A\cdot(1\text{-}\alpha\cdot\gamma\cdot U_{R,n}))} .$$

6. Method according to one of the claims 1 or 2, **characterized in that** a correction value ($\gamma_i$) is determined for each of the measurement intervals ($t_i$) and an average value is formed from these correction values ($\gamma_i$) over the measurement period.

7. Method according to one of the preceding claims, **characterized in that** the emission value ($U_E$) and the reflectance value ($U_R$) change periodically with a period length during the deposition of the layer (23 to 31) or a multilayer structure (21) consisting of several layers (23 to 31), wherein the temporal duration of a measurement interval ($t_i$) is less than a quarter or a tenth of the period length and that the total duration of all measurement intervals ($t_i$) is greater than a quarter of the period length or a multiple of the period length.

8. Method according to one of the preceding claims, **characterized in that** the measurement duration or the number of measurement intervals ($t_i$) used to determine the correction value ($\gamma$) is kept constant and/or that the correction value ($\gamma$) changes over time.

9. Method according to one of the preceding claims, **characterized in that** the correction value ($\gamma$) is optimized continuously during the deposition of one or more layers on the substrate, and/or that the correction value ($\gamma$) is updated with each newly determined measurement value pair ($\{U_{E,n}, U_{R,n}\}$), and/or that a constant number or a number of measurement value pairs that varies within a predetermined range is used to calculate the correction value ($\gamma$).

10. Method according to one of the preceding claims, **characterized in that** the temperature value ($T_C$) is an actual value with which a temperature control device (5, 6') for controlling the temperature of the substrate (22) is regulated with respect to a setpoint (s).

11. Measuring device with one or more optical measuring devices (10, 11), which are set up to repeatedly measure successive measurement value pairs ($\{U_{E,n}, U_{R,n}\}$) which each contain an emission value ($U_E$) and a reflectance value ($U_R$), several times in succession in a device for depositing layers, and having a computing device (15), which is capable of calculating an actual value (TC) of a temperature of the surface of the layer using a correction value ($\gamma$), **characterized in that** the computing device (15) is programmed in such a way that the correction value ($\gamma$) is determined according to a method according to one of claims 1 to 10.

12. Device for depositing layers on a substrate with a gas inlet element (2) arranged in a reactor housing (1), through which process gases are fed into a process chamber (8), a susceptor (4) having a surface facing towards the process chamber (8) which can be heated by a heating device (5) and on whose surface facing the process chamber (8) substrates (22) can be arranged, with one or more optical measuring devices (10, 11) for measuring an emission value ($U_E$) and a reflectance value ($U_R$) of a broad side of the substrate (22) facing towards the process chamber (8), and with a control device for regulating the temperature of the substrate (22) using the emission values ($U_E$) and reflectance values ($U_R$) measured by the at least one optical measuring device (10, 11), wherein a computing device (15) determines a correction value ($\gamma$) and can calculate an actual value ($T_C$) of the temperature using the correction value ($\gamma$), **characterized in that** the measuring device is designed according to Claim 11.

**Revendications**

1. Procédé de revêtement d'un substrat (22) avec au moins une couche (23 à 31), sachant que pendant la dépose de la couche (23 à 31), des paires de valeurs de mesure ({$U_{E,n}$, $U_{R,n}$}), qui contiennent respectivement une valeur d'émission ($U_E$), qui correspond à la puissance de rayonnement mesurée à une longueur d'ondes de lumière et une valeur de réflectance ($U_R$), qui est également mesurée à une longueur d'ondes de lumière avec au moins un système de mesure optique (10, 11) sont déterminées à plusieurs reprises les unes derrière les autres sur la couche (23 à 31), sachant qu'avec les relations $U_E = A \cdot e^{\frac{B}{T}} \cdot (1 - \alpha \cdot \gamma \cdot U_R)$ et $U_E = C(CT) - C(T) \cdot \alpha \cdot \gamma \cdot U_R$ des valeurs de températures ($T_C$) d'une température de substrat sont calculées à partir des paires de valeurs de mesure ({$U_{E,n}$, $U_{R,n}$}), sachant que

   A,B: sont des paramètres d'étalonnage avec B < 0,
   $\alpha$ est un paramètre d'étalonnage de la normalisation de réflectance, qui établit avec $0 \leq R \leq 1$ la corrélation entre le signal de mesure ($U_R$) et la réflectance physique R,
   $\gamma$ est une valeur de correction à déterminer et
   C(T) est un facteur dépendant de la température avec

$$\mathrm{C}(\mathbb{T}) = A \cdot e^{\frac{B}{T}}$$

   **caractérisé en ce que**, pendant une durée de mesure à l'intérieur d'un grand nombre (k) d'intervalles de mesure ($t_i$), au moins deux paires de valeurs de mesure ({$U_{E,n}$, $U_{R,n}$}) sont respectivement mesurées et un facteur dépendant de la température ($C_i(T_i)$) qui est utilisé pour le calcul de la valeur de correction ($\gamma$) est déterminé pour chacun des intervalles de mesure ($t_i$).

2. Procédé selon la revendication 1, **caractérisé en ce que** le facteur ($C_i(T_i)$) est respectivement obtenu par une régression des valeurs d'émission ($U_E$) réduites par les valeurs de réflectance ($U_R$) ou par le biais d'un procédé d'optimisation.

3. Procédé selon l'une quelconque revendications précédentes, **caractérisé en ce que** des valeurs d'émission ($U'_E$) normalisées sont constituées par les valeurs d'émission ($U_E$) enregistrées dans au moins quelques-uns des intervalles de mesure en divisant par le facteur respectif ($C_i(T_i)$)
   avec

$$U'_E = \frac{U_{E,n}}{c_i(T_i)} = (1 - \alpha \cdot \gamma \cdot U_{R,n})$$

   et la valeur de correction ($\gamma$) est calculée par une régression par le biais des valeurs d'émission ($U'_E$) normalisées réduites des des valeurs de réflectance ($U_R$) ou par un procédé d'optimisation.

4. Procédé selon la revendication 4, **caractérisé en ce que** la valeur de correction ($\gamma$) est constituée à partir de la pente d'une droite de compensation par les valeurs d'émission ($U'_E$) normalisées.

5. Procédé selon l'une quelconque des revendications 1 ou 2, **caractérisé en ce que** la valeur de correction ($\gamma$) est obtenue en adaptant des valeurs de température ($T_i$), qui sont obtenues à partir des facteurs ($C_i(T_i)$)

   avec

$$Ti = B/ln\left(\frac{c_i(T_i)}{A}\right)$$

à des valeurs de température (T'$_i$), qui sont calculées à partir des valeurs de mesure respectives ({$U_{E,n}$, $U_{R,n}$}) avec

$$T_i' = \frac{B}{\ln(U_{E,n}) - \ln\left(A \cdot (1\text{-}\alpha \cdot \gamma \cdot U_{R,n})\right)}.$$

6. Procédé selon l'une quelconque des revendications 1 ou 2, **caractérisé en ce qu'**une valeur de correction ($\gamma_i$) est respectivement déterminée pour chacun des intervalles de mesure (t$_i$) et une valeur moyenne est constituée sur la durée de mesure, à partir desdites valeurs de correction ($\gamma_i$).

7. Procédé selon l'une quelconque des revendications précédentes, **caractérisé en ce que** la valeur d'émission ($U_E$) et la valeur de réflectance ($U_R$) varient périodiquement avec une longueur de période pendant la dépose de la couche (23 à 31) ou d'une structure multicouches (21) composée de plusieurs couches (23 à 31), sachant que la durée dans le temps d'un intervalle de mesure (t$_i$) est plus petite qu'un quart ou qu'un dixième de la longueur de période et **en ce que** la durée totale de tous les intervalles de mesure (t$_i$) est plus grande qu'un quart de la longueur de période ou d'un multiple de la longueur de période.

8. Procédé selon l'une quelconque des revendications précédentes, **caractérisé en ce que** la durée de mesure ou le nombre des intervalles de mesure (t$_i$) utilisés pour la détermination de la valeur de correction ($\gamma$) est maintenu(e) constant(e) et/ou **en ce que** la valeur de correction ($\gamma$) varie dans le temps.

9. Procédé selon l'une quelconque des revendications précédentes, **caractérisé en ce que** la valeur de correction ($\gamma$) est optimisée en continu pendant la dépose d'une ou plusieurs couches sur le substrat et/ou **en ce que** la valeur de correction ($\gamma$) est actualisée avec chaque paire de valeurs de mesure nouvellement déterminée ({$U_{E,n}$,$U_{R,n}$}) et/ou **en ce qu'**un nombre constant ou un nombre variant dans une plage prédéterminée de paires de valeurs de mesure est utilisé pour le calcul de la valeur de correction ($\gamma$).

10. Procédé selon l'une quelconque des revendications précédentes, **caractérisé en ce que** la valeur de température (T$_C$) est une valeur réelle avec laquelle un système de thermorégulation (5, 6') est régulé pour thermoréguler le substrat (22) par rapport à une valeur théorique (s).

11. Dispositif de mesure avec un ou plusieurs systèmes de mesure optiques (10, 11), qui sont agencés pour déterminer dans un dispositif de dépose des paires de valeurs de mesure ({$U_{En}$, $U_{R,n}$}) à plusieurs reprises les unes derrière les autres, qui contiennent respectivement une valeur d'émission ($U_E$) et une valeur de réflectance ($U_R$), et avec un système de calcul (15), qui est en mesure de calculer une valeur réelle (T$_C$) d'une température de surface de la couche en utilisant une valeur de correction ($\gamma$), **caractérisé en ce que** le système de calcul (15) est programmé de telle façon que la valeur de correction ($\gamma$) est déterminée d'après un procédé selon l'une quelconque des revendications 1 à 10.

12. Dispositif de dépose de couches sur un substrat avec un organe d'admission de gaz (2) disposé dans un carter de réacteur (1), par lequel les gaz de traitement sont acheminés dans une chambre de traitement (8), un suscepteur (4) comportant une surface tournée vers la chambre de traitement (8), qui peut être chauffé par un dispositif de chauffage (5) et sur la surface tournée vers le chambre de traitement (8) duquel peuvent être disposés des substrats (22), avec un ou plusieurs systèmes de mesure (10, 11) optiques pour la mesure d'une valeur d'émission ($U_E$) et d'une valeur de réflectance ($U_R$) d'une face large du substrat (22) tournée vers la chambre de traitement (8) et avec un système de régulation pour réguler la température du substrat (22) en utilisant les valeurs d'émission ($U_E$) et valeurs de réflectance ($U_R$) mesurées par au moins un système de mesure optique (10, 11), sachant qu'un système de calcul (15) détermine une valeur de correction ($\gamma$) et peut calculer une valeur réelle (T$_C$) de la température en utilisant la valeur de correction ($\gamma$), **caractérisé en ce que** le dispositif de mesure est conçu selon la revendication 11.

Fig.1

Fig.2

## Fig. 3

| | | | |
|---|---|---|---|
| PGaN | | 60nm | 21, 31 |
| AlGaN | Barriere | 11nm | 30 |
| GaN-2 | Puffere | 1050nm | 29 |
| GaN-1 | Puffere | 320nm | 28 |
| AlGaN-3 | Transition | 730nm | 27 |
| AlGaN-2 | Transition | 410nm | 26 |
| AlGaN-1 | Transition | 170nm | 25 |
| HT-AIN | Nukleation | 160nm | 24, 23 |
| Si(111) | | 1000µm | 22 |

## Fig. 4

$t_i$ $t_{i+1}$ $U_E$

$U_E , U_R$

$t_k$

$t$

$U_R$

## Fig. 5

$t_1$  $t_2$  $t_3$  $t_4$  $t_5$

$t_k$

## Fig. 6

$$U_E = C_i(T_i) \cdot (1 - \alpha \cdot \gamma_i \cdot U_R)$$

$C_i(T_i)\alpha \cdot \gamma_i$

$\{U_E , U_R\}$

$C_i(T_i)$

$$C_i(T_i) = A \exp\left(\frac{B}{T_i}\right)$$

**Fig. 7**

**Fig. 8**

## Fig. 9

$$T_i = B \cdot \ln\left(\frac{A}{c_i(T_i)}\right)$$

$T_1$  $T_2$  $T_3$  $T_4$  $T_5$

$t_1$  $t_2$  $t_3$  $t_4$  $t_5$

## Fig. 10

$$T'_n = \frac{B}{\ln(U_{E,n}) - \ln(A \cdot (1 - \alpha \cdot \gamma_k \cdot U_{R,n}))}$$

$T'_2$  $T'_4$  $T'_5$  $T'_7$  $T'_8$  $T'_{11}$  $T'_{14}$

$T_3$
$T_2$
$T_1$

n = 1 2 3 4 5 6 7 8 9 10 11 12 13 14 15

$t_1$  $t_2$  $t_3$  $t_4$  $t_5$

## *Fig. 11*

Neues Messwertpaar
$\{U_E, U_R\}$

Berechnung von
$C_i(T_i), T_i, \gamma_i$ aus
neuem Teilintervallen
$t_i$ und Verschiebung
oder Erweiterung des
Intervalls $t_k$ um $t_i$

Bewertung,
ob neues
Messwertpaar
verwendbar
ist

ja

nein

Keine Neuberechnung
von $\gamma_k$

(A) Normierung der
$U_E$ Werte:
Berechnung von $U´_E$

(B) Berechnung des
Temperatur
Verlaufs mit einem
Fit an $T_i$ über $t_k$

(C) Mittelung oder
Fit an die $\gamma_i$ Werte
über $t_k$, um den
aktuellen $\gamma_k$ zu
bestimmen

Berechnung von
$\gamma_k$ aus $U´_E(U_R)$
Wertepaaren über
$t_k$ mit beliebigem
Algorithmus

Anpassung von
$\gamma_k$, bis der
Unterschied
zwischen $T_i$ und
Messwerten über
$t_k$ minimal wird

Gegebenenfalls
Auswahl der besten
Berechnungsmethode
und Filterung von
$\gamma_k(t)$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6398406 B1
- DE 102018106481 A1
- DE 4419476 C2
- DE 102020111293 A1
- DE 102020126597 A1

**In der Beschreibung aufgeführte Nicht-Patentliteratur**

- **W. G. BREILAND**. *Technical Report SAND2003-1868*, June 2003